(19) Europäisches Patentamt
European Patent Office
Office européen des brevets

(11) **EP 2 791 969 B1**

(12) **FASCICULE DE BREVET EUROPEEN**

(45) Date de publication et mention
de la délivrance du brevet:
**09.03.2016 Bulletin 2016/10**

(21) Numéro de dépôt: **12801563.3**

(22) Date de dépôt: **13.12.2012**

(51) Int Cl.:
*H01L 21/768* (2006.01)     *H01L 23/48* (2006.01)
*H01L 23/498* (2006.01)     *H01L 23/00* (2006.01)
*H01L 25/00* (2006.01)      *H05K 1/11* (2006.01)

(86) Numéro de dépôt international:
**PCT/EP2012/075364**

(87) Numéro de publication internationale:
**WO 2013/087760 (20.06.2013 Gazette 2013/25)**

(54) **FORMATION D'UNE CONNEXION ELECTRIQUE DU TYPE VIA**

HERSTELLUNG EINER ELEKTRISCHEN DURCHGANGSVERBINDUNG

FORMING A VIA ELECTRICAL CONNECTION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.12.2011 FR 1161643**

(43) Date de publication de la demande:
**22.10.2014 Bulletin 2014/43**

(73) Titulaire: **Commissariat à l'Énergie Atomique
et aux Énergies Alternatives
75015 Paris (FR)**

(72) Inventeur: **GERS, Roland
F-38000 Grenoble (FR)**

(74) Mandataire: **Decobert, Jean-Pascal
Cabinet Hautier
20, rue de la Liberté
06000 Nice (FR)**

(56) Documents cités:
**EP-A1- 2 075 828       WO-A1-2010/119652
DE-C1- 10 205 026       US-A1- 2010 164 117
US-A1- 2010 289 140**

**Description**

DOMAINE TECHNIQUE DE L'INVENTION

La présente invention concerne en général les interconnexions électriques de composants électroniques et notamment la réalisation, d'interconnexions perpendiculaires au plan des composants assemblées dans un empilement tridimensionnel de composants électroniques. Ces composants peuvent être tous dispositifs électroniques et en particulier microélectroniques ou nanoélectroniques ou encore des interposeurs.

ÉTAT DE LA TECHNIQUE

L'augmentation de la densité des dispositifs produits par l'industrie de la microélectronique passe désormais par l'assemblage tridimensionnel (3D) de composants indépendants sous forme d'un empilement de composants microélectroniques implémentant le plus souvent des fonctions électroniques mais qui peuvent aussi inclure des fonctions électriques, optiques voire mécaniques. Ces composants microélectroniques doivent pouvoir être interconnectés entre eux pour réaliser la fonction souhaitée. Une technique largement utilisée pour les interconnexions entre les différents plans d'un empilement consiste à créer des vias d'interconnexion perpendiculaires au plan des composants microélectroniques. Dénommés TSV, acronyme de l'anglais « through-silicon via », c'est-à-dire « via au travers du silicium », ils permettent d'interconnecter les deux faces d'un même substrat, le plus souvent en effet constitué de silicium, et donc les composants microélectroniques entre eux.

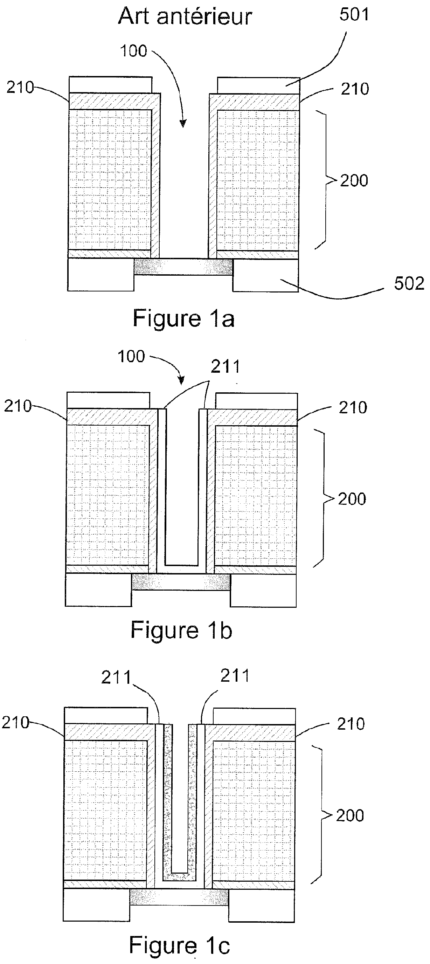

Un tel type de via ou TSV, qui doit traverser toute l'épaisseur d'un substrat sur lequel on a réalisé un certain type de composants microélectroniques, se fait d'une façon traditionnelle en trois étapes principales qui sont illustrées respectivement par les figures 1a, 1b et 1c.

Il faut d'abord pouvoir isoler électriquement le TSV d'un substrat 200 qu'il traverse. Une très bonne isolation électrique doit être réalisée afin de prévenir toute fuite de courant entre le conducteur que constitue le via et le substrat. Ceci doit être vrai en particulier pour les applications radiofréquences pour lesquelles les via doivent constituer des guides d'ondes parfaits.

Comme montré sur la **figure 1a**, ceci est recherché par la formation d'une couche 210 diélectrique isolante dans le trou 100 qui aura été créé préalablement dans le substrat 200 et qui le traverse complètement. Typiquement, le substrat 200 est fait de silicium et la couche 210 est obtenue par dépôt ou croissance d'oxyde de silicium ($SiO_2$) à partir du substrat ou par dépôt de SiON.

Ensuite, comme illustré sur la **figure 1b**, un fond continu conducteur 211 doit être déposé. Le fond continu conducteur a pour rôle, d'une part, de rendre possible un remplissage par électrolyse du TSV ; et d'autre part, d'empêcher au cours de cette opération toute diffusion vers le substrat du matériau conducteur qui va constituer le TSV en créant une barrière de diffusion. Une technique largement utilisée, dite ECD, acronyme de l'anglais « electrochemical deposition », c'est-à-dire « déposition électrochimique », permet en effet, à partir d'un électrolyte, de former le TSV en déposant électriquement un métal comme le cuivre. La qualité du résultat de l'électrolyse dépend largement des caractéristiques de la couche 211 et notamment de sa continuité et de son épaisseur. On notera qu'une lithographie réalisée avant l'ECD laisse seules ouvertes les zones de dépôt voulues, c'est-à-dire les surfaces internes des cavités formées par les trous 100.

La **figure 1c** illustre le résultat final. Le remplissage destiné à former le TSV est partiel, en réalisant donc un conducteur cylindrique creux, comme représenté mais qui peut aussi être plein.

Les étapes de formation d'un TSV brièvement décrites ci-dessus deviennent particulièrement critiques avec la diminution du facteur de forme des trous dans lesquels les TSV sont formés. Le plus souvent de section circulaire, mais en rien limité à cette seule forme, le facteur de forme est défini ici comme étant le rapport entre le diamètre du trou sur sa profondeur nécessaire pour traverser le substrat. Dans un assemblage tridimensionnel, pour augmenter la densité des interconnexions perpendiculaires au plan des composants microélectroniques, il est très avantageux de pouvoir obtenir des facteurs de forme faibles. Cependant, pour des facteurs de forme typiquement inférieurs à 0,5, les techniques communément employées pour former la couche diélectrique 210 et le fond continu conducteur 211 servant de barrière de protection atteignent leurs limites. Ces techniques, de type PVD ou PECVD, acronymes de l'anglais « physical vapor deposition » et « plasma-enhanced chemical vapor deposition », c'est-à-dire, respectivement, «déposition physique en phase vapeur » et « déposition chimique en phase vapeur activée par plasma » ne permettent plus d'obtenir des dépôts uniformes et continus. Par exemple, pour un facteur de forme de 0,5 et une profondeur de 200 $\mu$m (1 $\mu$m = $10^{-6}$ mètre), un dépôt de 4 $\mu$m de diélectrique en surface donne lieu à un dépôt de seulement 0,6 $\mu$m au fond et au centre du via et à un dépôt encore moindre de 0,3 $\mu$m sur les flancs en bas de la cavité.

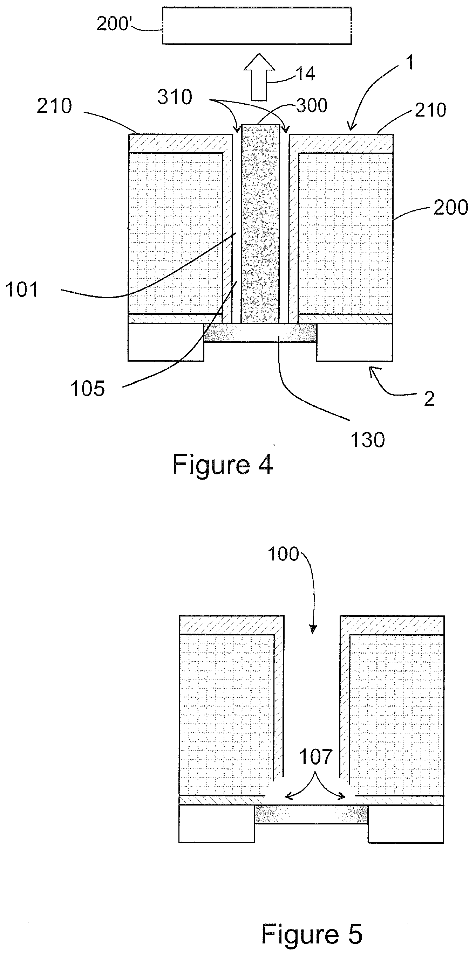

La **figure 5** illustre un défaut d'isolation de la couche diélectrique 210 qui ne couvre pas toute la hauteur du trou en particulier dans la zone 107. Dans des trous 100 à facteur de forme faible, il peut se produire des défauts d'isolation en particulier, comme représenté, au fond des trous là où l'épaisseur du dépôt tend à être plus faible. Si le substrat 200 a été surgravé en fond de trou 100 (au moyen d'une action de crantage ou ajourage, aussi connue avec le vocable anglais « notching ») le dépôt est alors absent en fond de cavité car les flancs sont masqués. WO2010/119652 A1 décrit un composant électronique de l'art antérieur avec des vias traversant un substrat, dans lequel les vias sont autoportants et maintenus en position avec un organe de maintien.

D'une manière générale, les techniques actuelles de réalisation d'un élément conducteur dans un via sont problématiques en terme de qualité de la conduction électrique qu'il produit, notamment en terme d'isolation électrique entre le trou de via et l'élément conducteur traversant.

C'est donc un objet de l'invention que de proposer une technique qui réponde au moins en partie aux problèmes rencontrés actuellement lors de la formation de connexions électriques telles des TSV.

Avantageusement, avec la présente invention, des difficultés liées à des dépositions dans le trou ne seront plus pénalisantes pour la qualité de l'isolation. On notera que ce type de défaut est avantageusement compensé par le procédé de l'invention où l'on peut préférentiellement utiliser comme élément conducteur d'électricité un pilier de section réduite par rapport au trou ce qui laisse un espacement qui peut préférentiellement servir d'isolant dans ces endroits critiques notamment avec la présence de vide, d'air ou d'un autre gaz capable d'agir comme isolant électrique.

Dans une mode de réalisation avantageux non limitatif, l'invention permet de former des TSV à faibles facteurs de forme.

Les autres objets, caractéristiques et avantages de la présente invention apparaîtront à l'examen de la description suivante et des dessins d'accompagnement. Il est entendu que d'autres avantages peuvent être incorporés.

RÉSUMÉ DE L'INVENTION

La présente invention est relative à un composant électronique comportant un substrat, au moins un trou traversant au moins en partie l'épaisseur du substrat et un élément électriquement conducteur situé dans le trou et configuré pour former une connexion électrique au travers du trou, comme divulgué dans la revendication 1.

L'élément électriquement conducteur comporte un pilier électriquement conducteur et dont la hauteur est orientée suivant l'épaisseur du substrat. Il comporte aussi un espace entre au moins une partie de la paroi du trou et une partie de la paroi périphérique du pilier. L'espace peut être du vide, ou bien encore au moins partiellement empli d'air ou d'un autre gaz diélectrique.

On notera que le pilier est autoportant et ne nécessite pas une reprise d'effort continue sur sa périphérie pour préserver son intégrité et sa forme au travers du trou. Cela permet de créer ou préserver un espace entre au moins une partie de la hauteur de ce pilier et la paroi du trou qui lui fait face. Tout risque de conduction électrique entre pilier et paroi du trou à ce niveau est ainsi évité.

L'espace est préférentiellement produit lors d'une phase de réalisation du pilier dans le trou, ce qui peut inclure une étape de création du pilier par déposition électrochimique. L'espace est avantageusement généré par un diamètre réduit du pilier relativement au diamètre du trou qui peut être défini par le diamètre intérieur d'une paroi soit d'une couche d'isolation directement formée sur la paroi de la cavité du trou du substrat, soit d'une couche de fond continu formée sur ladite couche d'isolation.

Dans un mode de réalisation non limitatif, le pilier est intégralement formé par déposition électrochimique.

Parmi les caractéristiques avantageuses de la présente invention, figurent les options non limitatives qui suivent et qui peuvent être indifféremment combinées :

- l'organe de maintien est configuré pour fermer l'espace de manière étanche à l'air,
- l'organe de maintien est situé au niveau d'une première extrémité du trou,
- le composant comporte au moins un autre organe de maintien espacé du premier organe de maintien suivant la hauteur du pilier,
- il comprend une zone de reprise de contact électrique au niveau d'une deuxième extrémité du trou, et le pilier comporte un organe conducteur en contact avec la zone de reprise de contact électrique et avec une partie de tronc du pilier. Le matériau de l'organe conducteur est alors avantageusement différent du matériau de la partie de tronc et présente une limite d'élasticité inférieure à celle du matériau de la partie de tronc,
- l'espace est clos,
- la paroi du trou est au moins partiellement formée par la surface d'une couche d'isolation,
- le substrat est au moins partiellement en matériau semi conducteur,
- le pilier comprend un tronc en cuivre,
- le matériau de l'organe de maintien et/ou le matériau de l'organe conducteur est un matériau fusible à plus basse température que le matériau du tronc du pilier,
- les organes de centrage divisent l'espace en plusieurs chambres,
- le composant comporte plusieurs trous et plusieurs piliers dont deux au moins sont de hauteurs différentes.
- l'espace est au moins partiellement empli d'au moins une matière diélectrique.

La matière en question peut être de l'air, un autre gaz sans charges électriques ou un matériau solide isolant tel une résine polymère.

L'invention est aussi relative à un procédé de création d'une connexion électrique au travers d'au moins une partie de l'épaisseur d'un substrat d'un composant électronique, comprenant les étapes de la revendication 9.

Le procédé peut présenter au moins l'une des caractéristiques purement optionnelles suivantes :

- la mise en contact de l'organe de maintien et de la paroi du trou est opérée par déformation plastique de l'organe de maintien, l'effort exercé pour opérer cette déformation plastique étant préférentiellement configuré pour ne pas déformer plastiquement au moins une autre partie du pilier telle un tronc de pilier.
- la déformation plastique de l'organe de maintien est opérée par compression ou thermo-compression du pilier présent dans le trou,
- la formation de l'organe de maintien comporte le dépôt, sur une partie de tronc du pilier, d'une couche d'un matériau constitutive de l'organe de maintien, ledit matériau étant sélectionné pour que sa limite d'élasticité soit inférieure à celle du matériau de la partie de tronc,
- la mise en contact est configurée pour fermer l'espace de manière étanche à l'air,
- l'organe de maintien est positionné au niveau d'une première extrémité du trou,
- la formation du pilier comprend la formation d'au moins un autre organe de maintien espacé du premier suivant la hauteur du pilier,
- le matériau de l'organe de maintien est un alliage, le procédé comprenant la transformation dudit alliage en intermétallique après la mise en contact de l'organe de maintien et de la paroi du trou,
- la formation du pilier comprend la réalisation d'un organe conducteur à la base d'une partie de tronc du pilier, le matériau de l'organe conducteur ayant une limite d'élasticité inférieure à celle du matériau de la partie de tronc, le procédé comprenant en outre la déformation plastique de l'organe conducteur par compression ou thermo-compression du pilier, au contact d'un élément d'appui électriquement conducteur,
- il comprend l'utilisation, comme élément d'appui, d'une zone de reprise de contact électrique formée au niveau d'une deuxième extrémité du trou,
- la formation du pilier comporte la formation d'un tronc de pilier d'un diamètre inférieur à celui du trou et la formation de l'organe de maintien avec un diamètre inférieur à celui du trou, et dans lequel la mise en contact comprend la compression ou la thermo-compression de l'organe de maintien de sorte à accroître sa section jusqu'au contact de la paroi du trou.
- la formation du pilier comporte une étape de fabrication du pilier à partir d'un deuxième substrat différent du substrat et une étape d'insertion du pilier dans le trou,
- avantageusement le pilier est réalisé de sorte que, après son insertion dans le trou, un espace est présent entre au moins une partie du pilier et la paroi du trou. Dans cette situation, les tolérances d'alignement entre premier et deuxième substrats peuvent être plus larges tout en garantissant une bonne réalisation de l'insertion du pilier dans le trou.

La formation du pilier peut en outre comporter une étape de fabrication du pilier à partir d'un deuxième substrat différent du substrat, et une étape d'insertion du pilier dans le trou.

L'étape de fabrication du pilier peut comporter la formation d'un tronc de pilier de diamètre inférieur au diamètre du trou et la formation de l'organe de maintien avec un diamètre supérieur au diamètre du trou.

La mise en contact peut comprendre la déformation plastique d'une portion périphérique de l'organe de maintien au contact d'une portion de surface du trou lors de l'étape d'insertion.

Suivant d'autres caractéristiques optionnelles, le procédé de l'invention peut être telle que :

- le matériau constitutif de l'organe de maintien est choisi pour avoir une limite d'élasticité inférieure à celle du matériau de la portion de surface du trou,
- le second substrat est retiré après l'étape d'insertion de façon à ne laisser subsister que le pilier dans le substrat,
- la formation du pilier comprend :

    1°) une étape de remplissage du trou par une résine ;
    2°) une étape de lithographie dans la résine configurée pour former un motif de pilier ;
    3°) une étape de dépôt dans le motif, d'au moins une couche de matériau constitutive du pilier ;
    4°) et, à titre préféré, une étape de retrait au moins partiel de la résine.

- le procédé peut comprendre, avant l'étape de remplissage, une étape de dépôt d'une couche de fond continu électriquement conductrice dans le trou, l'étape de dépôt étant opérée par déposition électrochimique.

Le premier substrat est préférentiellement réalisé tout ou partie en matériau semi-conducteur par exemple en silicium ou éventuellement en germanium mais il peut-être réalisé également à base de diélectrique et par exemple en verre.

Le second substrat peut-être retiré ou non après l'étape d'insertion du pilier dans le premier substrat. Lorsque le second substrat est conservé, il peut éventuellement comporter des éléments ou composants électroniques.

Le procédé peut comporter, après l'étape d'insertion ou de réalisation du pilier dans le trou, une étape de compression ou de thermo compression du pilier dans le trou de manière à renforcer le contact électrique entre le pilier reporté et le substrat.

Avantageusement il comprend une réalisation d'une base en matériau conducteur placée en correspondance d'une extrémité du trou et constituant un organe conducteur. On forme ainsi un support pour le pilier et une continuité de conduction électrique vers une face du premier substrat.

Avantageusement l'organe de maintien est un matériau fusible à basse température par exemple en alliage d'étain ou d'indium. On peut tirer ainsi profit de propriétés de déformation plastique possible pour ce matériau à température relativement basse.

Avantageusement l'organe conducteur est en matériau fusible à basse température qui peut-être le même ou différent de celui de l'organe de maintien et par exemple en alliage d'étain ou d'indium. Pour ces organes, on choisira de préférence des matériaux fusibles basses températures c'est à dire présentant une température de fusion très inférieure à celle du reste du pilier ou tout au moins son tronc qui doit rester rigide pendant l'insertion.

L'espace intermédiaire entre la paroi du trou et périphérie du pilier peut être fermé aux extrémités du trou, notamment dans le cas particulier où le second substrat est retiré, après l'étape d'insertion.

Avantageusement le pilier est tout ou partie en cuivre et préférentiellement au niveau de son tronc.

Avantageusement la couche d'isolation réalise au moins une partie de la paroi du trou.

Selon une alternative, la couche d'isolation est déposée avant l'étape d'insertion, sur le second substrat de façon à isoler le pilier, sauf à l'extrémité du pilier destinée à venir en contact avec la zone de reprise de contact.

Le pilier est préférentiellement réalisé à partir d'un deuxième substrat qui peut être en matériau semi conducteur.

La présente invention concerne aussi un composant électronique obtenu selon le procédé de l'invention,.

L'invention est aussi relative à un système électronique qui comporte au moins deux composants électroniques de l'invention situés en empilement de sorte que leurs éléments électriquement conducteurs soient en contact,

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

Les figures 1a à 1c illustrent l'art antérieur et les étapes principales de la formation d'un TSV par déposition électrochimique. Les éléments 501 et 502 symbolisent respectivement la technologie faces arrière et avant autour du TSV.

Les figures 2a à 2c illustrent un principe de mise en oeuvre de l'invention dans un mode de réalisation où l'on prépare un pilier conducteur sur un substrat de report qui va servir à remplir un TSV sur le substrat hôte fonctionnel.

Les figures 3a à 3c illustrent un exemple de fabrication d'un pilier sur un substrat de report.

La figure 4 montre un exemple d'une structure de TSV obtenue avec le procédé de l'invention après enlèvement du substrat de report.

La figure 5 illustre le cas d'un défaut d'isolation de la couche diélectrique au fond du trou destiné à recevoir le pilier conducteur.

Les figures 6a à 6c illustrent différents cas de piliers composites utilisant au moins deux types de matériaux différents.

La figure 7 montre un composant à plusieurs connexions électriques au travers de son épaisseur dans un exemple d'application de l'invention à la réalisation de cartes à pointes destinées au test de puces sur tranche avant découpage.

La figure 8 montre un autre exemple de l'invention pour former un ensemble électronique en empilement pour la réalisation de cartes à pointes aptes à tester des puces sur tranche dont les plots de soudage sont très espacés en hauteur.

La figure 9 représente l'intégration possible de l'invention pour des applications de cartes à pointes.

Les figures 10 à 13 illustrent des étapes successives d'une variante possible de l'invention dans laquelle le pilier n'est pas issu d'un report. Plus précisément, la figure 10 schématise un état initial du trou. La figure 11 montre une phase de préparation avec des dépositions. La figure 12 montre la formation d'un motif dans de la résine déposée dans le trou. La figure 13 présente une connexion électrique avec un pilier résultant des étapes précédentes, après enlèvement de la résine.

La figure 14 illustre une variante du mode de réalisation de la figure 13 avec un pilier composite.

La figure 15 montre la configuration du pilier composite de la figure 14 après déformation plastique d'une partie du pilier.

Les dessins joints sont donnés à titre d'exemples et ne sont pas limitatifs de l'invention.

DESCRIPTION DÉTAILLÉE DE L'INVENTION

Comme indiqué précédemment, l'invention s'adresse à la formation de connexions électriques telles des via au travers de tout composant microélectronique, incluant tout type de dispositif réalisé avec des moyens de la microélectronique. L'expression « composant microélectronique» englobe notamment des dispositifs micromécaniques ou électromécaniques, tels les MEMS (micro-electromechanical systems) ou les NEMS (nano-electromechanical systems) ainsi que les dispositifs optiques ou optoélectroniques (tels les MOEMS micro optical electromechanical systems).

Le via ci-après aussi éventuellement nommé TSV peut être même réalisé sur un dispositif à fonction électrique tel une carte à pointes.

La connexion électrique du composant ici proposée peut servir à raccorder électriquement deux éléments du composant électronique situés sur des faces différentes ou à raccorder le composant à au moins un autre composant électronique qui peut être de tout type.

L'invention peut aussi servir à raccorder électriquement deux composants électroniques séparés par le composant comprenant la connexion électrique de l'invention.

Avant d'exposer en détail le procédé de l'invention, avec notamment la mise en oeuvre d'une étape de report ou, en alternative, la formation complète du pilier 300 à partir du substrat 200 du composant, on présente ci après des structures reflétant des modes de réalisation avantageux du composant électronique de l'invention.

Une première configuration de via est donnée à la figure 4 qui présente un pilier autoportant en contact, par sa base, avec une zone de reprise de contact 130. On entend par autoportant que le pilier 300 est à même à supporter son propre poids. Il peut donc, comme représenté, se maintenir suivant sa hauteur dans le trou 100 par simple appui de sa base sur la zone de reprise de contact.

Le pilier 300 est ici un élément fait d'une pièce d'une seule matière, monobloc. Il s'agit avantageusement d'un élément cylindrique de section circulaire et plein.

Sa paroi périphérique, correspondant à sa surface extérieure située en regard de la paroi 101 du trou 100, ne contacte pas la paroi 101 sur au moins une partie de la hauteur du pilier 300. Un espace 105 est ainsi produit. Dans le cas de la figure 4, cet espace 105 est clos à une extrémité du trou 100 située à la base du pilier (appelée deuxième extrémité par la suite, par convention) grâce à la zone de reprise de contact 130 au niveau d'une face 2 du composant. Par contre, l'espace est ouvert en partie haute du trou (appelée première extrémité par la suite, par convention).

Dans le cas de la figure 4, la paroi 101 du trou 100 est formée, au moins partiellement par une couche d'isolation 210, obtenue par exemple par déposition, et couvrant avantageusement aussi, au niveau de la face 1 du composant, une portion du substrat 200 (ci après aussi dénommé premier substrat) située du coté de la première extrémité.

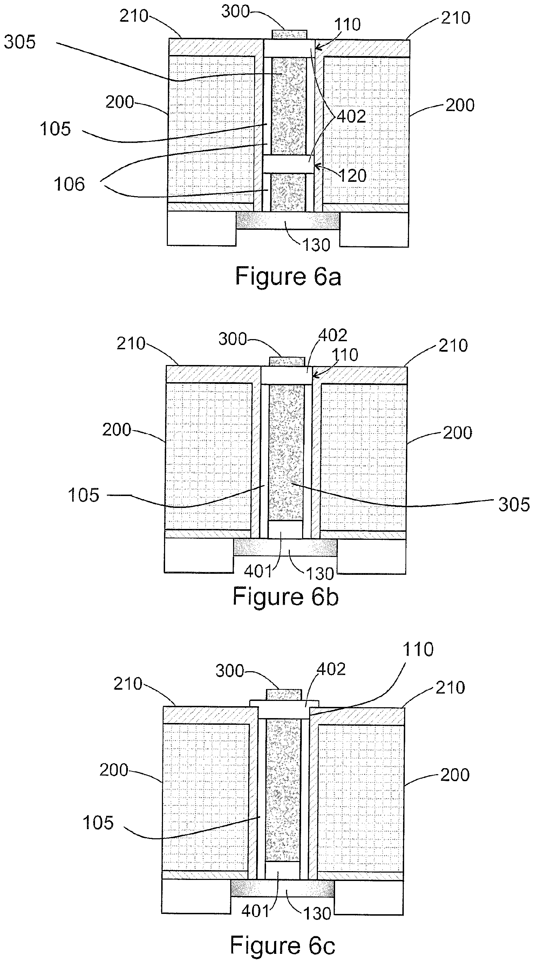

Une variante du cas de la figure 4 est exposée à la figure 6a sur laquelle le pilier 300 est composite en ce qu'il comprend, suivant sa hauteur, plusieurs tronçons de configurations différentes. Plus particulièrement, le pilier 300 comporte au moins une partie 305 de tronc. Le tronc s'entend ici d'un corps principal du pilier constituant préférentiellement plus de la moitié de sa hauteur et/ou constitué dans un matériau à la limite d'élasticité supérieure aux autres parties du pilier.

Le tronc est avantageusement de diamètre inférieur au diamètre du trou de sorte à produire l'espace 105. Dans l'illustration, le tronc comporte plusieurs parties 305 séparées par d'autres composants du pilier. Ainsi, deux organes de centrage 402 sont formés : en partant de la base du pilier, ce dernier possède une partie de tronc puis un organe de maintien 402 au contact de la paroi 101 du trou 100 au niveau d'une zone 120, ensuite une deuxième partie 305 de pilier est présente, puis un autre organe de maintien 402 également au contact de la paroi 101 dans la zone 110, puis une autre partie de tronc, les zones 110, 120 sont préférentiellement des appuis cylindres sur cylindre. Le contact est préférentiellement tel qu'une fermeture étanche à l'air est produite. Le contact de l'organe de maintien 402 est donc avantageusement orienté suivant la hauteur du trou 100. Le contact concerne préférentiellement au moins une portion de la paroi du trou 100 orientée suivant la hauteur de ce dernier.

Un seul organe de maintien 402 peut être formé ou plus de deux. Un organe de maintien 402 est préférentiellement positionné au niveau de la première extrémité du trou 100. En procédant ainsi, on forme un espace 105 clos de grande dimension suivant la hauteur du pilier 300.

Une fonction de l'organe de maintien peut être de caler latéralement le pilier 300. Le ou les organes de maintien 402 peuvent être électriquement conducteurs de sorte à assurer une continuité de conduction selon la hauteur du pilier 300.

La présence de plusieurs organes de centrage 402 divise l'espace 105 en plusieurs chambres 106.

EP 2 791 969 B1

D'une manière générale, chaque organe de maintien 402 peut être une partie, avantageusement non entière, de la hauteur du pilier 300. Il s'agit préférentiellement d'un tronçon correspondant à une zone superposée à d'autres zones, suivant la hauteur du pilier 300.

La figure 6b illustre la formation d'un espace 105 d'un seul tenant, avec un seul organe de maintien 40, affleurant à la face 1 du composant située au niveau de la première extrémité du trou 100. A la base du pilier 300, un organe conducteur 401 forme un raccordement entre une partie 305 de tronc de pilier et la zone de reprise de contact électrique 130.

L'organe conducteur 401 est avantageusement configuré pour optimiser le contact électrique entre le pilier et la zone 130.

Une variante de la figure 6b est donnée en figure 6c avec un organe de maintien 402 formant bouchon pour l'espace 105 et disposant d'une portion cylindrique s'appliquant sur la paroi 101 du trou 100 à la zone 110. L'organe 402 est aussi pourvu d'une collerette par exemple formée par une portion cylindrique de plus grand diamètre et s'appliquant sur la bordure du trou 100 au niveau de la face 1 du composant située à la première extrémité du trou 100.

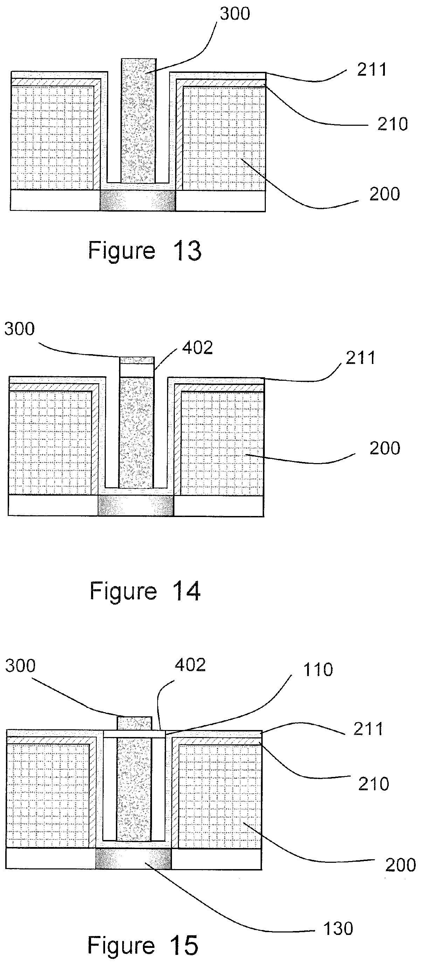

La figure 15 montre une autre variante de structure de connexion électronique dans le composant, variante dans laquelle le pilier est doté d'un seul organe 402. Cet organe s'applique, en 110, sur la paroi 101 du trou ici formée par une couche de fond continu 211. Avantageusement, à la base du pilier, la couche de fond continu 211, électriquement conductrice, assure le raccordement électrique entre pilier 300 et zone de reprise de contact 130.

A titre indicatif, l'espace 105, qu'il soit d'une seul tenant ou divisé en plusieurs chambres 106, peut s'étendre sur au moins 50% de la hauteur du substrat 200 (c'est-à-dire son épaisseur).

Certaines caractéristiques des différents modes de réalisation ci-dessus décrits seront détaillées dans la suite de la description qui expose en outre des exemples de procédé de réalisation de la connexion électrique du type via. Les divers modes de réalisation de l'invention, qu'il s'agisse du composant, du procédé ou du système électronique associant des composants peuvent être combinés dans leurs caractéristiques. Ainsi, par exemple, le pilier de la figure 15 pourrait comporter plusieurs organes de centrage 402, comme c'est le cas en figure 6a, ou un organe conducteur 401.

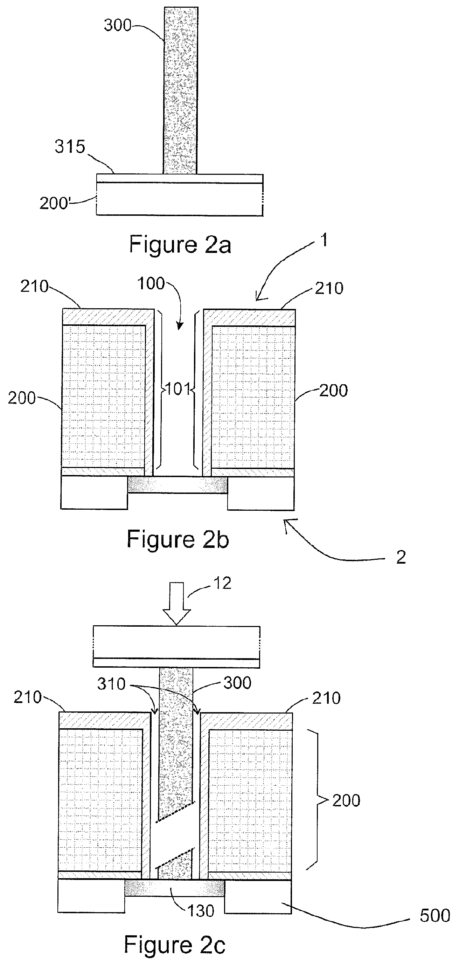

En référence aux figures 2a, b, c, 3a, b, c, 4 et 6a, b, c, on décrit ci-après un premier mode de réalisation d'un procédé de fabrication d'un composant électronique incluant la création d'une connexion électrique au travers du substrat 200. Suivant ce premier mode de réalisation, une partie du via est créée sur un deuxième substrat 200', le premier substrat 200 et le deuxième substrat 200' constituant globalement deux modules à assembler.

*Description des modules à assembler :*

La description qui suit explique la formation d'un via dans un substrat au moyen de l'invention. Il est bien évident que ce cas peut être étendu à une pluralité de vias dans ledit substrat sans sortir du cadre de l'invention.

Les **figures 2a à 2c** illustrent le principe de mise en oeuvre de l'invention où l'on prépare le remplissage du TSV à partir d'un second substrat.

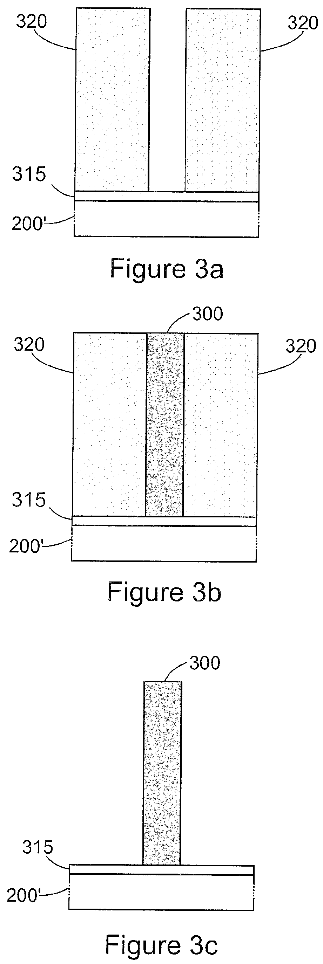

La figure 2a montre ce second substrat 200' où l'on a fait croître un pilier conducteur 300 dont on va se servir pour remplir le TSV comme expliqué ci-après. Le second substrat 200' est un substrat de report ou « poignée » de manipulation qu'on enlève avantageusement après report du pilier. L'invention ne fait pas d'hypothèse sur la nature du pilier conducteur 300 ni sur la façon dont il a été obtenu. Un exemple de formation d'un pilier est cependant décrit ci-après dans les figures 3a à 3c où l'on réalise comme dans l'art antérieur une croissance de ce dernier par déposition électrochimique (ECD) par exemple de cuivre. Dans ce cas il faut aussi disposer d'un fond continu conducteur pour l'électrolyse qui est masqué pour y délimiter l'emplacement des piliers. On remarquera cependant qu'il s'agit alors d'une couche 315 complètement plane disposée sur le second substrat 200' et dont on peut contrôler parfaitement la structure et les dimensions pour que l'électrolyse puisse se faire dans les meilleures conditions possibles. On remarquera aussi qu'il est possible dans ce mode de réalisation de faire croître des piliers qui ne sont pas nécessairement composés d'un seul et même matériau conducteur. Des piliers composites peuvent être réalisés, avec des éléments 401 et 402 de matériaux, formes et dimensions différents, et des éléments 402 eux-mêmes potentiellement différents.

Les figures 3a à 3c montrent plus en détail la création du pilier 300 sur le deuxième substrat 200'.

La figure 3a montre l'ouverture qui est pratiquée dans la résine photosensible qui a été déposée lors de l'opération de lithographie qui permet de définir la position et la section des piliers à la surface du substrat de report 200' et de la couche 315 formant le fond continu conducteur. L'épaisseur de résine déposée correspond à la hauteur du pilier 300 que l'on veut réaliser.

La figure 3b montre la structure obtenue à l'issue du dépôt électrochimique du matériau constituant les TSV, typiquement du cuivre, dont la croissance s'est effectuée dans les zones non masquées par la résine créant ainsi, par électrolyse, un pilier 300.

La figure 3c montre la structure obtenue après enlèvement de la résine. Cette structure est conforme à celle de la figure 2a.

La figure 2b montre le premier substrat 200 qui a la même structure que dans l'art antérieur à l'exception notable du fait qu'il n'est pas nécessaire de devoir y former le fond continu conducteur pour la déposition électrochimique. Seule la couche diélectrique isolante 210 est présente dans le cas illustré. Elle constitue la paroi 101 du trou 100.

*Le report proprement-dit :*

La figure 2c illustre une étape de report d'un pilier depuis le second substrat 200' qui est la poignée de manipulation, sur le substrat hôte fonctionnel, c'est-à-dire le premier substrat 200. Le pilier 300 est aligné en regard du trou 100 puis comprimé légèrement par une force appliquée 12, de manière à établir une continuité électrique avec la zone de reprise de contact inférieure 130 en métal. Les surfaces de contact sont avantageusement préalablement désoxydées pour faciliter le contact électrique.

Le support du substrat hôte 200 qui contient le ou les trous formant les cavités destinées à recevoir les piliers est préférentiellement dessiné de manière à bien répartir la compression, en offrant une large surface d'appui notée 500. La force appliquée nécessaire à la déformation plastique de l'organe 402 est toutefois relativement réduite, de l'ordre du kilogramme par exemple. De plus, l'essentiel de l'énergie fournie par la force appliquée est convertie en énergie de déformation de l'élément 402.

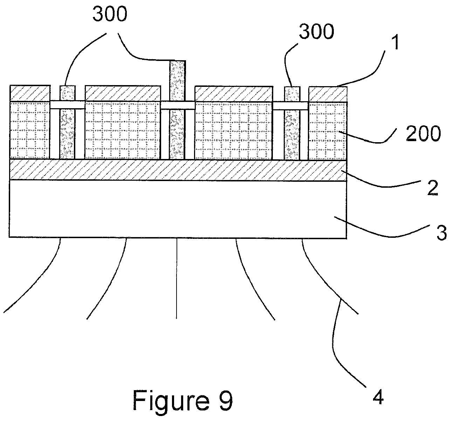

Le contact métallique en fond de trou 130 pourra être avantageusement renforcé en sa base pour ne pas risquer d'être arraché lors du report du pilier notamment dans le cas où l'option d'un pilier 300 complètement rigide a été retenue. Il est ainsi possible que la surface d'appui 500 serve aussi à reprendre les efforts de compression induits par le pilier 300 et transmis par la zone 130. La surface d'appui 500 peut notamment être en contact avec la face de la zone 130 opposée au pilier 300. La topologie de surface peut donc contenir des éléments, utiles ou non à la constitution des circuits électroniques, participant à la constitution d'une surface d'appui comme cela est présenté en figure 9.

En fonction des matériaux choisis, le report peut s'effectuer aussi bien puce à puce ou plaque à plaque (connu équivalemment avec le vocable anglais « wafer »), à chaud comme à froid. Le report du composant microélectronique sur substrat peut se faire à partir de motifs d'alignement comme lors d'un report classique de composants microélectroniques. Le pilier 300 ou les piliers sont mis en vis-à-vis avec les cavités, centrés à une hauteur qui tient compte de la hauteur des piliers. Les piliers sont ensuite insérés dans les cavités formées par chaque trou 100 correspondant puis mis en contact à l'aide d'une force adaptée 12 (cf. figure 2c où la flèche symbolise un effort suivant la hauteur du pilier 300) au nombre et à la surface des piliers.

Le substrat de report ou substrat poignée 200' peut être désolidarisé du pilier reporté 300 par des moyens chimiques, c'est-à-dire par exemple, respectivement, par une gravure sélective de la couche 315 située au pied du pilier, ou bien par des moyens mécaniques, par un cisaillement par exemple. Pour la configuration présentée sur les figures 2a à 2c, le pilier est avantageusement réalisé comme expliqué dans les figures 3a à 3c dans un métal, par exemple du cuivre, qui est déposé sur un fond continu 315 de titane et de cuivre. Dans ce cas, un bain de peroxyde d'hydrogène ($H_2O_2$) et d'acide sulfurique ($H_2SO_4$) est utilisé pour attaquer chimiquement la base du pilier 300 jusqu'à provoquer la séparation du substrat poignée 200' du pilier 300. Dans une configuration où un organe conducteur 401 est présent, une couche de matériau fusible à plus basse température que le reste du pilier (non représentée sur les figures 2a à 2c) est ajoutée entre le fond continu 315 et le pilier 300, un cisaillement du substrat poignée par rapport au substrat contenant la cavité peut être effectué pour séparer le pilier de son support. Cette couche en matériau fusible à basse température située à la base du pilier est obtenue par électrolyse, comme le reste du pilier. Avantageusement, le choix du matériau à la base du pilier 300 sur le substrat 200' se portera sur un matériau de température de fusion plus basse que celui (ou ceux) qui peut s'insérer dans le corps du pilier 300 (comme l'organe 402 ou l'organe 401).

Le pilier reporté peut avoir sensiblement le diamètre laissé par la couche diélectrique isolante 210 dans le trou. Très avantageusement, il peut être aussi, comme représenté, d'un diamètre inférieur, par exemple 70 $\mu$m pour un trou de diamètre 80 $\mu$m dans le cas d'un pilier en cuivre et un alliage d'étain. L'insertion du pilier 300 en sera facilitée en limitant l'exigence d'alignement pour le substrat report 200' sur le substrat 200 et l'espace 105, présent entre le pilier et les parois intérieures du trou, contribue à améliorer l'isolation électrique apportée par la couche diélectrique 210. On peut également combler au moins en partie l'espace 105 entre le pilier et le substrat 200 par un matériau polymère servant d'isolant électrique.

La **figure 4** montre un exemple de structure de TSV obtenue avec le procédé de l'invention après enlèvement 14 du substrat de report 200'. La figure 4 montre le cas où le pilier est de section plus réduite pour laisser une couche d'air entre ce dernier et les parois du trou avec les avantages déjà mentionnés ci-dessus. Dans ce cas la paroi 101 du trou 100 est faite d'un matériau diélectrique isolant sous forme de la couche 210 décrite précédemment.

La conduction électrique, généralement, ne se fait pas dans tout le diamètre du pilier et il n'est donc pas absolument nécessaire de remplir complètement le pilier comme représenté dans les figures annexes. Ce dernier peut aussi être creux, par exemple de forme cylindrique creuse.

Les **figures 6a à 6c** illustrent différents cas de piliers composites c'est-à-dire de piliers utilisant au moins deux types de matériaux différents dont l'un est plus malléable que l'autre afin de conférer des caractéristiques avantageuses particulières aux TSV fabriqués selon le procédé de l'invention comme décrit ci-après.

La **figure 6a** montre un premier type de structure utilisant un pilier 300 composite dont on a fait varier la composition au cours de sa croissance, par exemple, par électrolyse. Dans l'exemple de la figure 6a le pilier composite comporte suivant sa hauteur deux zones correspondant aux organes de centrage 402 d'un même matériau malléable ou de deux matériaux malléables différents, un pour chacune des zones. Le pilier 300 est par exemple réalisé avec les étapes suivantes, comprenant la réalisation d'une première partie en cuivre correspondant au tronc du pilier et une deuxième en étain (qui correspond aux zones 402). Les zones 402 ont une largeur maximale (ou diamètre en cas de section circulaire) qui dépasse de la largeur (ou le diamètre) du reste du pilier. Pour obtenir ce résultat, on peut avantageusement associer du cuivre qui va constituer le corps principal du pilier 300 de remplissage et un alliage d'étain qui est en effet un métal ayant une limite d'élasticité inférieure et qui est par ailleurs malléable à température ambiante. Cette association confère au pilier composite des propriétés très avantageuses :

-   sous l'effet de la pression 12 illustrée sur la **figure 2c** et exercée sur le substrat de report 200' lors de l'insertion des piliers, le matériau de l'organe conducteur 402 va pouvoir s'écraser par déformation plastique jusqu'à venir toucher les parois 101 du trou et de ce fait obturer la cavité que forme le trou 100. La figure 6a et les suivantes représentent les strates de matériau malléable d'un piler après écrasement de celui-ci et obturation de la cavité. Les différentes sections de la cavité ainsi formées seront isolées de l'atmosphère extérieure et ne seront plus susceptibles d'être altérées par les traitements physicochimiques que l'on doit appliquer sur la surface du dispositif en cours de fabrication. Par exemple, la gravure mentionnée précédemment de la base du pilier qui permet de libérer le substrat de report 200' ne pourra pas avoir d'influence néfaste sur le TSV en cours de fabrication.

-   L'écrasement des organes de centrage 402 dans l'exemple de la figure 6a va de plus permettre un auto centrage du pilier dans le trou, assurant ainsi l'existence d'une couche d'air tout autour du pilier ce qui contribue très significativement à l'isolation électrique de ce dernier comme on l'a vu.

À titre d'exemple de la pression 12 qu'il faut pouvoir exercer : 64 piliers 300 de $58\mu$m de diamètre initial, composés de cuivre et d'un alliage d'étain, sont écrasés sous une charge de 3 kilogrammes (kg).

Un alliage à base d'étain (Sn) qui convient à la formation d'un pilier 300 composite va par exemple aussi comprendre de l'argent (Ag) et du cuivre (Cu). D'autres matériaux peuvent convenir comme l'indium (In). Un alliage à base de plomb (Pb) serait aussi susceptible de convenir mais pose des problèmes de pollution. L'emploi du plomb tend en effet à être banni par toute l'industrie de la microélectronique.

La **figure 6b** illustre le cas où un organe conducteur 401 dans un matériau différent, et notamment en alliage d'étain, est aménagé à ce qui est devenu l'extrémité inférieure du pilier 300 après qu'il a été inséré dans le trou 100 et séparé du substrat 200' de report. Destiné à venir en contact avec la zone de reprise de contact 130 (celle qui va permettre l'interconnexion avec l'élément sous jacent de l'assemblage tridimensionnel) l'objectif de l'organe conducteur 401 est d'améliorer la qualité électrique de ce contact. Si l'extrémité du pilier 300, c'est-à-dire la zone 401 dans ce cas, est réalisée à partir d'un matériau plus malléable que celui servant à d'autres parties telles le tronc ou au reste du pilier 300, le cuivre par exemple, il faudra contrôler la compression générée par la force 12 de manière à ce qu'il ne vienne pas toucher les bords de la cavité formée par le trou 100, là où potentiellement l'isolation est défaillante comme illustré dans la figure 5. On notera que c'est préférentiellement sur le paramètre de limite d'élasticité que l'on joue pour sélectionner les matériaux constituant le pilier 300. Cette limite d'élasticité donne la contrainte maximale qu'un matériau peut supporter en restant dans sa phase de déformation réversible dite élastique.

D'une manière générale, on s'arrange pour que la limite d'élasticité des matériaux des parties du pilier 300 formant les organes de centrage 402 et l'organe conducteur 401 soit inférieure (par exemple d'au moins 50%) à celle(s) formant le tronc. A noter qu'on peut employer, pour l'organe de maintien 402 et l'organe conducteur 401 un même matériau ou des matériaux différents.

Le dimensionnement des épaisseurs de matériaux malléables pour la réalisation des zones déformables plastiquement des piliers composites peut se faire en fonction du rapport des limites élastiques des matériaux qui le composent.

Par exemple, avec le cuivre pour former les parties 305 de tronc du pilier 300 et l'étain ou l'indium pour former les parties du type organe de maintien 402 et organe conducteur 401, on a les propriétés suivantes :

|  | Tfusion (°C) | CTE (ppm/°C) | Contrainte à rupture (MPa) | Limite élastique (MPa) | Allongement max. (%) | Module d'Young (GPa) |
|---|---|---|---|---|---|---|
| Cuivre | 1084 | 17 | 230 | 60 | 30 | 120 |
| Etain pur | 232 | 20 | 15 | 10 | 75 | 42 |

(suite)

|  | Tfusion (°C) | CTE (ppm/°C) | Contrainte à rupture (MPa) | Limite élastique (MPa) | Allongement max. (%) | Module d'Young (GPa) |
|---|---|---|---|---|---|---|
| indium | 156 | 29 | 3 | 2 | 50 | 13 |

Les déformations latérale et verticale étant plastiques pour les organes 401 et 402, il convient de connaître la loi d'écoulement du matériau à une contrainte donnée, à une vitesse de déformation donnée et à une température donnée pour calculer le diamètre initial de ces parties du pilier 300 que l'on peut obtenir. Ces lois spécifiques à chaque matériau sont accessibles à partir de tests de compression. Pour un alliage d'étain argent et cuivre appelé communément SAC, il a été obtenu un doublement du diamètre du pilier au niveau d'un organe 401 ou 402, pour une épaisseur de quelques microns. Le volume de l'organe déformable plastiquement est quasiment constant lors de la compression en première approximation.

Plus le pilier 300 sera étroit, meilleure sera l'isolation puisque l'espace 105, tel une couche d'air, sera alors plus importante. La couche malléable 402 située le plus près de la surface à la première extrémité du trou 100 a un rôle supplémentaire de bouchon. Ce bouchon préserve avantageusement l'enceinte de la cavité de toute intrusion. Dans tous les cas, un espace 105 tel une couche d'air de quelques microns (par exemple 1 à 15 microns) est envisageable autour du pilier.

La figure 6c illustre une alternative où la couche malléable 402 sort partiellement hors de la couche d'isolation 210 superposée au substrat 200. Dans cette situation ou dans les précédentes, l'organe de maintien 402 peut être originellement créé avec un diamètre supérieur à celui du tronc du pilier et à celui du trou 100 de sorte que l'organe 402 accoste le bord du trou 100 lors de l'insertion et qu'il est déformé plastiquement au contact du bord du trou 100. En arrêtant l'insertion avant que l'organe ne pénètre totalement dans le trou 100, on obtient la configuration de la figure 6c.

Pour éviter que l'appui opéré par le ou les organes de centrage 402 ne dégrade la paroi 101 du trou 100, il est préféré de choisir pour cette paroi la surface d'un matériau dont la limite d'élasticité est supérieure à celle du ou des organes 402.

La technique de fabrication de vias traversant un substrat de type TSV selon le procédé de l'invention qui est décrit dans les figures précédentes présente de nombreux avantages dont les principaux sont rappelés ci-après.

- Les piliers 300 que l'on réalise séparément peuvent être contrôlés et caractérisés facilement en cours de production car ils émergent du substrat de report 200'.
- Le dépôt par électrolyse des piliers est facilité par le fait que le fond continu 215 nécessaire à l'électrolyse est parfaitement plan car il est maintenant déposé, avant croissance des piliers, sur le substrat de report qui est lui-même plan. Dans ces conditions le fond continu peut être parfaitement homogène sur toute sa surface : en épaisseur et composition.
- Il n'est donc plus nécessaire comme dans l'art antérieur illustré par les figures 1 a à 1 c qu'un fond continu soit déposé dans les trous 100 du substrat où l'on forme les vias. Dans la technique traditionnelle le fond continu est indispensable pour que le dépôt électrochimique puisse se faire. En outre, on s'affranchit de la difficulté inhérente à la continuité d'une barrière à la diffusion du métal du TSV dans le matériau du substrat, par exemple le silicium.
- La couche diélectrique 210 peut être de qualité moindre (épaisseur, propriétés intrinsèques) du fait que le pilier de touche pas les bords du substrat 200 de silicium, sauf aux endroits où la ou les zones 402 de matériau malléable du pilier composite s'écrasent comme représenté notamment sur la figure 6a. Dans un mode de réalisation, le pilier 300 est, avant report, recouvert d'une couche d'isolation électrique par toute technique appropriée telles les dépositions PVD et PECVD. On retire simplement, par exemple par polissage type CMP la couche isolante ainsi formée au niveau de la base du pilier 300 par laquelle le pilier 300 sera inséré dans le trou.

Les zones 402 sont avantageusement placées suffisamment loin du fond du trou 100 pour éviter de se trouver en contact avec une couche diélectrique incomplète. Sur l'exemple d'un trou de 200μm de profondeur qui présente en son embouchure une couche d'isolation 210 de 3μm et une épaisseur nulle dans le pire cas tout en fond de via, et en assimilant le profil de dépôt de la couche isolante à un triangle, la distance de l'organe 402 le plus enfoncé dans le trou au fond du trou est de 30μm pour être en contact avec une couche isolante en SiO2 de 500nm, choisie comme une épaisseur garantissant une bonne isolation. Cette distance h est donnée par

$$h = \frac{épaisseur\, de\, la\, couche\, d'isolation\, 210\, en\, bas}{épaisseur\, de\, la\, couche\, d'isolation\, 210\, en\, haut} . profondeur\, du\, trou\, 100$$

(théorème de Thalès)

Plus haut, l'épaisseur de diélectrique est suffisante pour assurer une bonne isolation. De plus, si le substrat a été surgravé au fond du trou comme représenté sur la figure 5, il y a une absence complète de la couche d'isolation 210 à cet endroit. Comme on l'a déjà noté ceci est avantageusement compensé par le procédé de l'invention où l'on laisse une couche d'air autour du pilier 300 qui suffit seule à servir d'isolant à ces endroits critiques.

- Pour augmenter les performances de la barrière de diffusion, on a recours à des températures de dépôt élevées, supérieures à 300°C pour la plupart des matériaux susceptibles de convenir (TiN, Ru, TaN...), températures qui ne sont pas toujours supportables par les circuits et composants du substrat. Des températures élevées permettent d'obtenir que le matériau soit déposé sous forme amorphe. Sous cette forme il constitue une meilleure barrière pour prévenir la diffusion. L'invention permet de se passer du dépôt d'une barrière et donc des problèmes liés à des températures élevées.
- On notera aussi que le remplissage peut avantageusement se faire sur un volume plus réduit le temps d'électrolyse est également réduit et donc le coût. La production du via est ainsi accélérée. De plus, les substrats peuvent être moins lourds, tout en conservant de bonnes propriétés mécaniques.
- La compression, ou thermo compression de la zone de contact 401, si besoin, permet de rendre plan le substrat qui porte le ou les piliers. Les défauts d'uniformité d'un dépôt électrochimique sont en effet toujours de l'ordre de quelques pourcents pour les dimensions considérées (généralement inférieurs à 5%), ce qui pourrait créer une difficulté lors du montage des piliers sur le substrat. Ces défauts d'uniformité sont ainsi avantageusement compensés par le procédé de l'invention.
- Pour les dispositifs qui doivent travailler à des températures élevées la couche d'air offre une liberté de mouvement au pilier ; on évite avantageusement des problèmes de contrainte de dilatation.

L'ajout des organes 402 et/ou 401 de matériau fusible (malléable) à basse température et/ou de limite élastique inférieure à celle constituant le tronc du pilier 300 permet également de limiter la dilatation dans le plan perpendiculaire au substrat 200 (suivant la hauteur du pilier 300), de manière à ne pas développer de délamination en faces avant et arrière du substrat, dans le cas où le ou les composants assemblés soient amenés à travailler en température, soit pour terminer le procédé de fabrication, soit en service.

En effet, de par ses propriétés mécaniques, l'organe 402 et/ou l'organe 401 peut se déformer plastiquement sous l'action des contraintes engendrées par la dilatation des zones intermédiaires formées par les parties 305 de tronc.

L'alliage d'étain, d'argent et de cuivre (SnAgCu) indiqué précédemment se dilate plus que le cuivre à des températures comprises entre 20°C et 250°C. Les coefficients de dilatation valent en effet, respectivement : 22 x 10-6 et 17 x 10-6 entre 20°C et 100°C. Un pilier associant dépôt de cuivre et dépôt de l'alliage ci-dessus est donc avantageux pour compenser la dilatation par déformation plastique et limiter la mise sous contrainte du substrat lors d'un fonctionnement à température élevée ce qui procure un gain significatif en fiabilité et tenue mécanique d'un dispositif utilisant le procédé de l'invention.

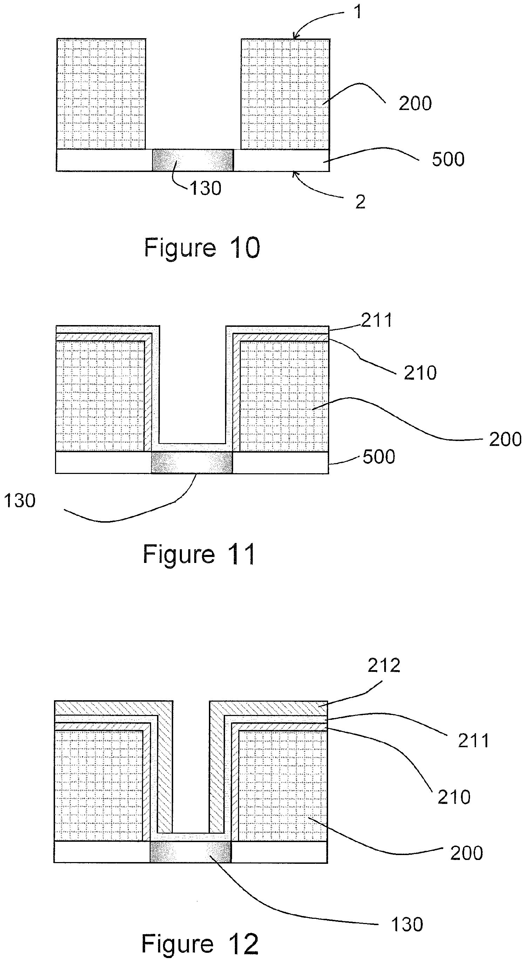

Un autre mode de réalisation du procédé de l'invention est illustré par les figures 10 à 15. Dans cette variante, un report à partir d'un deuxième substrat 200' n'est pas nécessaire.

Le procédé, dans cet exemple, commence comme en **figure 10** par une gravure profonde du substrat 200 dans lequel on réalise une ouverture de dimension voulue et variable de, par exemple, 200 $\mu$m de profondeur par 75 $\mu$m de diamètre. Comme pour le procédé de report, un dépôt de couche 210 de diélectrique est fait à l'intérieur de la cavité du trou 100 et sur face 1 du substrat 200, la face 2 opposée étant la face comprenant la reprise de contact en fond de via 130 et la technologie résumée sous l'élément 500. L'élément 130 doit être isolé électriquement du substrat 200. Une gravure sèche de la couche 210 est réalisée pour laisser affleurer en fond de via l'élément conducteur 130. Contrairement au cas avec report de pilier, un fond continu métallique 211 est déposé sur l'élément 210. Ce fond continu 211 peut être classiquement composé d'une couche d'accroche (par exemple en titane) et d'une couche conductrice (par exemple de cuivre) sur la couche d'accroche. La couche de cuivre servira à amener le courant en fond de cavité lors d'une étape ultérieure de remplissage. Le résultat de la formation des couches d'isolation 210 et de fond continu 211 apparait en **figure 11**.

Suit une étape d'étalement de résine épaisse sur toute la face arrière jusqu'à combler le (ou les) via présent sur cette face. Une lithographie est effectuée pour former dans la couche de résine 212 un motif en faisant une ouverture préférentiellement centrée sur le via et de diamètre inférieur comme cela ressort de la **figure 12**.

La cavité définie par le motif est ensuite remplie avantageusement par un dépôt électrochimique. La technique employée peut être similaire à l'électrolyse envisagée pour le mode de réalisation avec report. Avant le dépôt électrochimique, la surface non couverte par la résine 212 de la zone 130 sera avantageusement préparée. Si le fond continu est composé entre autre de cuivre, la surface sera par exemple désoxydée par de l'acide sulfurique par exemple. La mouillabilité de la résine pourra être améliorée par un traitement plasma. Le dépôt peut être de un ou plusieurs matériaux. La résine est retirée au moins partiellement par voie chimique par exemple pour ne laisser que le dépôt qui a cru par électrochimie. On dispose ainsi d'un pilier 300 conducteur qui relie face avant et face arrière du composant et qui est isolé de la paroi de la cavité par une couche d'air à ce moment du procédé illustré par la **figure 13**. On peut ensuite procéder à la gravure du fond continu comme dans l'état de l'art.

On peut aussi avantageusement intégrer au dépôt électrochimique un dépôt d'un matériau fusible à basse température et/ou plus malléable que d'autres parties du pilier 300 pour constituer au moins un organe de maintien 402 tel qu'en **figure 14**. Ce matériau malléable aura une limite élastique plus faible que le matériau constituant le tronc du pilier 300 et avantageusement une capacité d'allongement importante, de l'ordre de plusieurs dizaines de pourcent. Si on vient appliquer une force sur le haut du pilier, comme vu précédemment, l'organe 402 se déformera plastiquement jusqu'à toucher la paroi 101 du trou 100, car il présente une limite élastique plus basse que l'élément métallique qui constitue le tronc du pilier 300. On peut par exemple choisir le cuivre pour le tronc du pilier 300 et pour l'organe 402 un alliage d'étain comme le SAC, à base également de cuivre et d'argent. Cette pression peut être appliquée sur plusieurs via en même temps, même à l'échelle de la plaque si jamais le but cherché est d'avoir des piliers reportés de même taille.

De cette façon, on peut arriver à une structure de pilier 300 qui est en contact avec la face 2 par l'élément 130 et qui est en appui sur les parois de la cavité du trou 100 grâce à l'organe de maintien 402 dans sa configuration de la **figure 15**. Cette structure facilite de plus la reprise de contact électrique avec une technologie en face arrière.

Ce mode de réalisation du procédé comporte plusieurs avantages. Comme pour le procédé de report, la couche d'air autour du pilier 300 dans la cavité améliore l'isolation du pilier. L'espace 105 de la cavité peut être bouché par un matériau malléable de manière à isoler la cavité de l'atmosphère et assure un maintien mécanique supplémentaire du pilier dans la cavité. Ce maintien peut se faire en haut de cavité là où l'épaisseur de diélectrique est conséquente, de l'ordre de $3\mu m$ pour un dépôt de $4\mu m$ de SiON en surface de la face 1 par exemple. Le ou les métaux du pilier ne risquent donc pas de diffuser vers le substrat 200.

Le procédé assure un bon contact électrique du pilier 300 avec le substrat 200 en fond de via, la croissance se faisant à partir de ce substrat 200. Le centrage est facilité car il se fait par des techniques lithographiques.

Un fond continu 211 est déposé, contrairement au cas du report du pilier, mais le pilier n'est pas séparé par gravure d'un second substrat. L'étape de gravure dans le cas d'un dépôt Titane-Cuivre ne dégrade pas le pilier en cuivre ou composite avec un alliage à base d'étain comme le SAC, les épaisseurs des couches de fond continu déposées sont bien plus faibles, de l'ordre de la centaine de nanomètres ($10^{-9}$m) à comparer à une épaisseur de plusieurs microns pour le pilier 300.

L'application d'une pression n'est pas obligatoire pour créer un contact intime entre le contact électrique 130 et le pilier.

Comme le procédé de report de pilier, ce procédé permet de se passer d'un dépôt de matériaux pour former une barrière de diffusion des espèces du pilier vers les parois latérales du substrat 200. Les barrières de diffusion se déposant principalement à haute température (plus de 300°C) pour favoriser le caractère amorphe des couches, on évite ainsi d'échauffer le substrat.

Comme le procédé de report de pilier, la croissance du pilier se fait de manière unidirectionnelle ici dans la résine depuis le fond du via ; la formation de trous dans le dépôt causé par une croissance simultanée à partir de la paroi latérale du via et du fond du via sont donc évités.

Le bouchonnage de la cavité du trou par un organe de maintien 402 par l'écrasement d'un matériau malléable peut se faire plaque à plaque ou localement.

Dans toutes ces variantes, le procédé de l'invention (avec ou sans report) peut être mis en oeuvre pour fabriquer des connexions à au moins un pilier 300 dans lequel l'espace 105 est comblé au moins en partie par un matériau diélectrique tel une résine isolante ou dans lequel le pilier est destiné à venir au contact d'une couche avantageusement électriquement isolante du composant. L'élément électriquement conducteur peut par ailleurs comprendre d'autres constituants que le pilier au travers de l'épaisseur du substrat.

Le procédé de l'invention et la structure de vias de type TSV qu'il permet d'obtenir peuvent être avantageusement utilisés pour des applications telles que la fabrication de cartes à pointes pour les tests électriques des puces avant leur découpage de la tranche sur laquelle ils ont été fabriqués. Les cartes à pointes sont conçues pour venir en contact, sur une machine de test, avec tous les points d'entrée et de sortie du chaque puce d'une tranche, généralement sur les plots de soudage qui seront utilisés pour les connexions avec le boîtier, afin que les circuits puissent être testés in situ sans avoir à les monter dans un boîtier. Ce qui évite bien sûr de monter les puces trouvées défectueuses sur la tranche.

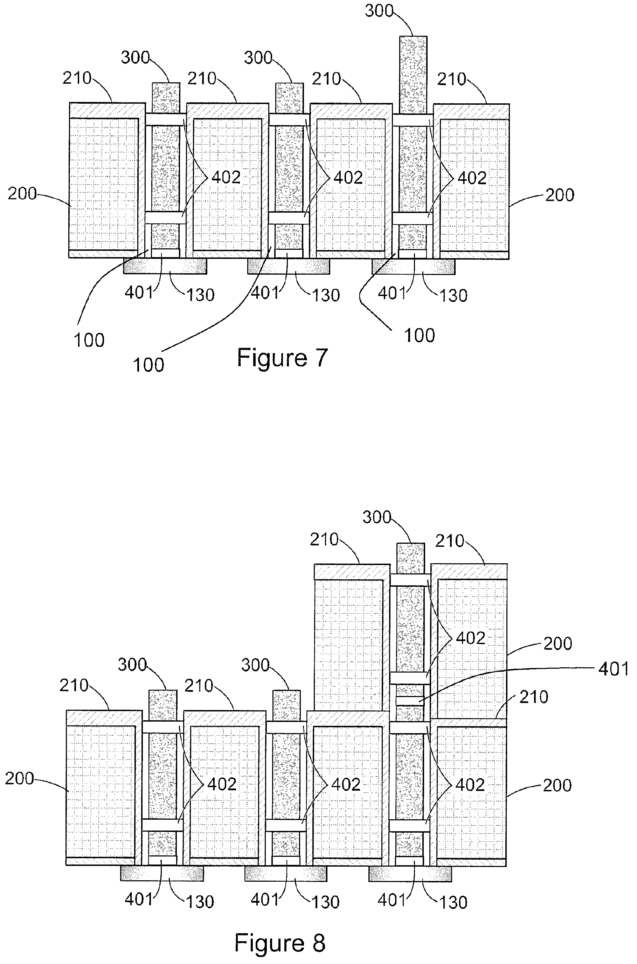

Comme montré sur les figures 3a à 3c le pilier 300 une fois libéré peut en effet être une pointe de test dont la hauteur peut être choisie en ajustant la hauteur de la couche de résine utilisée pour délimiter les zones où le dépôt électrochimique doit se faire. Des pointes avec un espacement très réduit, de l'ordre de quelques dizaines de microns, et de hauteurs variables, typiquement avec des différences de hauteur jusqu'à 50 $\mu m$, peuvent ainsi être fabriquées sur un même substrat 200 comme représenté sur la **figure 7**. Ceci est obtenu par un report successif de piliers de hauteurs différentes dans des trous 100 de même profondeur. Les trous 100 non bouchés lors d'un premier report peuvent accueillir d'autres piliers 300, lors d'un deuxième report. Les piliers de longueurs différentes sont préparés sur des substrats de report différents. Il y a autant de substrats de report que de longueur de pointes différentes à réaliser.

Enfin, pour tester simultanément un dispositif comportant des plots de soudage ayant des différences d'altitudes très importantes, typiquement supérieures à 50 $\mu$m, un système obtenu par assemblage de composants par empilement comme représenté sur la **figure 8** est possible en gardant la même idée, à savoir une soudure avec l'alliage fusible, d'épaisseur très faible (<2$\mu$m) pour qu'après la première compression il ne puisse plus se déformer, ou le moins possible. Une thermocompression pourra dans ce cas comme dans les autres même entraîner la formation d'intermétalliques entre les organes 402 et/ou 401 et le reste du pilier 300, qui auront une température de fusion plus élevée que celle du ou des matériaux des organes 402 et/ou 401 stabilisant davantage l'assemblage.

En particulier, la figure 8 montre la présence, à droite, de deux substrats 200 superposés et séparés par une couche d'isolation 210. Chaque pilier conducteur 300 fait saillie au-delà de la couche d'isolation 210. Les deux piliers conducteurs 300 qui sont superposés sont ainsi verticalement alignés et unis par la zone de contact 401 du pilier conducteur 300 supérieur, qui est compressé non plus sur la reprise de contact 130 mais sur une surface supérieure du pilier conducteur 300 qui reste au dessus de la structure inferieure.

La présente invention permet donc aussi de faciliter la superposition de composants donc de plusieurs substrats logeant des piliers conducteurs, qui sont introduits préalablement à la superposition des substrats eux-mêmes.

La figure 9 montre plus précisément une carte à pointe construite avec un substrat 200 au delà de la première face 1 duquel font saillie des pointes constituées par l'extrémité distale de piliers 300. Des technologies type CMOS peuvent être embarquées tant en face 1 qu'en face 2. On a aussi représenté des fils de connexion 4 du composant ainsi formé sur un support 3.

## Revendications

1. Composant électronique comportant :

    - un substrat (200) et au moins un trou (100) traversant au moins en partie l'épaisseur du substrat (200) ;
    - un élément électriquement conducteur situé dans le trou (100) et configuré pour former une connexion électrique au travers du trou (100), l'élément électriquement conducteur comportant un pilier (300) électriquement conducteur et autoportant dont la hauteur est orientée suivant l'épaisseur du substrat (200),
    - un espace (105) de vide ou au moins partiellement empli d'un gaz diélectrique entre au moins une partie de la paroi du trou (100) et une partie de la paroi périphérique du pilier (300) ;

    dans lequel le pilier (300) comporte un organe de maintien (402) en position du pilier (300) en contact avec la paroi (101) du trou (100) suivant la hauteur du trou (100), l'organe de maintien (402) étant un tronçon formant une partie de la hauteur du pilier (300) ;
    dans lequel l'organe de maintien (402) est en superposition avec une partie (305) de tronc du pilier (300) ;
    et dans lequel le matériau de l'organe de maintien (402) est différent du matériau de la partie (305) de tronc et présente une limite d'élasticité inférieure à celle du matériau de la partie (305) de tronc.

2. Composant selon la revendication précédente dans lequel l'organe de maintien (402) est configuré pour fermer l'espace (105) de manière étanche à l'air.

3. Composant selon l'une des revendications précédentes dans lequel l'organe de maintien (402) est situé au niveau d'une première extrémité du trou (100).

4. Composant selon l'une des revendications précédentes comportant au moins un autre organe de maintien (402) espacé du premier organe de maintien (402) suivant la hauteur du pilier (300).

5. Composant selon l'une des revendications précédentes comprenant une zone de reprise de contact électrique (130) au niveau d'une deuxième extrémité du trou (100), et dans lequel le pilier (300) comporte un organe conducteur (401) en contact avec la zone de reprise de contact électrique (130) et avec une partie (305) de tronc du pilier, et dans lequel le matériau de l'organe conducteur (401) est différent du matériau de la partie (305) de tronc et présente une limite d'élasticité inférieure à celle du matériau de la partie (305) de tronc.

6. Composant selon l'une des revendications précédentes dans lequel l'espace (105) est clos.

7. Composant selon l'une quelconque des revendications précédentes dans lequel le substrat (200) est au moins partiellement en matériau semi-conducteur et/ou la paroi du trou est au moins partiellement formée par la surface d'une couche d'isolation (210).

8. Composant selon l'une des revendications précédentes comportant plusieurs trous et plusieurs piliers (300) dont deux au moins sont de hauteurs différentes.

9. Procédé de création d'une connexion électrique au travers d'au moins une partie de l'épaisseur d'un substrat (200) d'un composant électronique, comprenant :

   - la formation d'un trou (100) traversant au moins une partie de l'épaisseur du substrat (200) ;
   - la formation d'un élément électriquement conducteur situé dans le trou (100) et configuré pour former la connexion électrique au travers du trou (100), la formation de l'élément électriquement conducteur comprenant :
   - la formation d'un pilier (300) autoportant électriquement conducteur faisant partie de l'élément électriquement conducteur (300) et dont la hauteur est orientée suivant l'épaisseur du substrat (200), la formation du pilier comportant la formation, dans le pilier (300), d'un organe de maintien (402) en position du pilier (300), le procédé comprenant en outre une mise en contact de l'organe de maintien (402) et de la paroi (101) du trou (100) suivant la hauteur du trou (100), la mise en contact de l'organe de maintien (402) et de la paroi (101) du trou (100) étant opérée par déformation plastique de l'organe de maintien (402),
   - la formation d'un espace (105) de vide ou au moins partiellement empli d'un gaz diélectrique entre au moins une partie de la paroi (101) du trou (100) et une partie de la paroi périphérique du pilier (300).

10. Procédé selon la revendication précédente dans lequel la déformation plastique de l'organe de maintien (402) est opérée par compression ou thermocompression du pilier présent dans le trou (100).

11. Procédé selon l'une des deux revendications précédentes dans lequel la formation de l'organe de maintien (402) comporte le dépôt, sur une partie (305) de tronc du pilier (300), d'une couche d'un matériau constitutive de l'organe de maintien (402), ledit matériau étant sélectionné pour que sa limite d'élasticité soit inférieure à celle du matériau de la partie (305) de tronc.

12. Procédé selon l'une des trois revendications, dans lequel la formation du pilier comprend la formation d'au moins un autre organe de maintien (402) espacé du premier suivant la hauteur du pilier (300).

13. Procédé selon la revendication 9 à 12, dans lequel le matériau de l'organe de maintien (402) est un alliage, le procédé comprenant la transformation dudit alliage en intermétallique après la mise en contact de l'organe de maintien (402) et de la paroi (101) du trou (100).

14. Procédé selon l'une des revendications 9 à 13 dans lequel la formation du pilier (300) comprend la réalisation d'un organe conducteur (401) à la base d'une partie de tronc du pilier (300), le matériau de l'organe conducteur (401) ayant une limite d'élasticité inférieure à celle du matériau de la partie de tronc, le procédé comprenant en outre la déformation plastique de l'organe conducteur (401) par compression ou thermocompression du pilier (300), au contact d'un élément d'appui électriquement conducteur, le procédé comprenant de préférence l'utilisation, comme élément d'appui, d'une zone de reprise de contact électrique (130) formée au niveau d'une deuxième extrémité du trou (100).

15. Procédé selon la revendication 11 seule ou en combinaison avec l'une des revendications 12 à 14 dans lequel la formation du pilier (300) comporte la formation d'un tronc de pilier (300) d'un diamètre inférieur à celui du trou (100) et la formation de l'organe de maintien (402) avec un diamètre inférieur à celui du trou (100), et dans lequel la mise en contact comprend la compression ou la thermocompression de l'organe de maintien de sorte à accroître sa section jusqu'au contact de la paroi (101) du trou (100).

16. Procédé selon l'une des revendications 9 à 15 dans lequel la formation du pilier comporte :

   - une étape de fabrication du pilier (300) à partir d'un deuxième substrat (200') différent du substrat (200),
   - une étape d'insertion du pilier (300) dans le trou (100).

17. Procédé selon l'une des revendications 9 à 14 dans lequel la formation du pilier comporte :

   - une étape de fabrication du pilier (300) à partir d'un deuxième substrat (200') différent du substrat (200),
   - une étape d'insertion du pilier (300) dans le trou (100) ;

   et dans lequel l'étape de fabrication du pilier comporte la formation d'un tronc de pilier de diamètre inférieur au diamètre du trou (100) et la formation de l'organe de maintien (402) avec un diamètre supérieur au diamètre du trou (100) ;
et dans lequel la mise en contact comprend la déformation plastique d'une portion périphérique de l'organe de maintien (402) au contact d'une portion de surface du trou (100) lors de l'étape d'insertion, avec de préférence le matériau constitutif de l'organe de maintien (402) choisi pour avoir une limite d'élasticité inférieure à celle du matériau de la portion de surface du trou (100).

18. Procédé selon l'une des deux revendications précédentes dans lequel le second substrat (200') est retiré après l'étape d'insertion de façon à ne laisser subsister que le pilier dans le substrat (200).

19. Procédé selon l'une des revendications 9 à 15 dans lequel la formation du pilier (300) comprend :

- une étape de remplissage du trou par une résine ;
- une étape de lithographie dans la résine configurée pour former un motif de pilier (300) ;
- une étape de dépôt dans le motif, d'au moins une couche de matériau constitutive du pilier (300) ;
- une étape de retrait au moins partiel de la résine,

et comprenant de préférence avant l'étape de remplissage, une étape de dépôt d'une couche de fond continu électriquement conductrice dans le trou, et dans lequel l'étape de dépôt est opérée par déposition électrochimique.

## Patentansprüche

1. Elektronisches Bauelement, das folgendes umfasst;

- einen Träger (200) und mindestens ein Loch (100), das durch mindestens einen Teil der Stärke des Trägers (200) hindurchführt;
- ein elektrisch leitendes Element, das sich in dem Loch (100) befindet und so aufgebaut ist, dass eine elektrische Verbindung durch das Loch (100) hergestellt wird, wobei das elektrisch leitfähige Teil eine elektrisch leitfähige, selbsttragende Säule (300) umfasst, deren Höhe sich nach der Stärke des Trägers (200) richtet.
- einen Zwischenraum (105), der leer ist bzw. zumindest teilweise zwischen mindestens einem Teil der Wand des Lochs (100) und einem anderen Teil der Außenwand der Säule (300) mit einem dielektrischen Gas gefüllt ist. in dem die Säule (300) ein Halteelement (402) für die Säule (300) umfasst, das je nach Höhe des Loches (100), mit der Wand (101) des Lochs (100) in Berührung ist wobei das Halteelement (402) ein Abschnitt ist, der Bestandteil der Höhe der Säule (300) ist;
- in welchem das Halteelement (402) einen Teil (305) des Abschnitts der Säule (300) überlagert;
- und in welchem sich das Material des Halteelements (402) vom Material des Teils (305) des Abschnitts unterscheidet und eine Streckgrenze aufweist, die niedriger ist als die des Materials des Teils (305) des Säulenabschnitts.

2. Bauelement nach vorhergehendem Patentanspruch, in dem das Halteelement (402) so konfiguriert ist, dass der Zwischenraum (105) luftdicht abgeschlossen ist.

3. Bauelement nach einem der oben genannten Patentansprüche, in welchem sich das Halteelement (402) in Höhe des ersten Endes des Loches (100) befindet.

4. Bauelement nach einem der vorhergehenden Ansprüche, das mindestes ein anderes Halteelement (402) enthält, dessen Entfernung vom ersten Halteelement (402) von der Höhe der Säule (300) abhängt.

5. Bauelement nach einem der vorhergehenden Patentansprüche, das einen Bereich für die Aufnahme eines elektrischen Kontakts (130) in Höhe des zweiten Endes des Loches (100) enthält, und in dem die Säule (300) ein leitfähiges Element (401) enthält, das in Berührung mit dem Bereich für die Aufnahme des elektrischen Kontakts (130) und mit einem Teil (305) des Säulenabschnitts ist, und in welchem sich das Material des leitfähigen Elements (401) vom Material des Teils (305) des Abschnitts unterscheidet und eine Streckgrenze aufweist, die unter der des Materials des Teils (305) des Abschnittes liegt.

6. Bauelement nach einem der vorhergehenden Patentansprüche, in dem der Zwischenraum (105) geschlossen ist.

7. Bauelement nach einem der vorhergehenden Patentansprüche, in dem der Träger (200) mindestens teilweise aus Halbleitermaterial besteht und/oder die Wand des Lochs zumindest teilweise von der Fläche einer Isolierschicht (210) gebildet wird.

8. Bauelement nach einem der vorhergehenden Patentansprüche, welches mehrere Löcher und mehrere Säulen (300) enthält, von denen mindestens zwei unterschiedlicher Höhe sind.

9. Verfahren zur Herstellung einer elektrischen Verbindung durch zumindest einen Teil der Dicke eines Trägers (200) eines elektronischen Bauelements, das folgende Schritte umfasst:

   - die Bildung eines Lochs (100), das durch mindestens einen Teil der Dicke des Substrats (200) führt;
   - die Bildung eines elektrisch leitfähigen Elements, das sich in dem Loch (100) befindet und so aufgebaut ist, dass eine elektrischen Verbindung durch das Loch (100) entsteht, wobei die Bildung des elektrisch leitfähigen Elements folgendes umfasst:
   - die Bildung einer selbsttragenden, elektrisch leitfähigen Säule (300), die Bestandteil des elektrisch leitfähigen Elements (300) ist, und deren Höhe sich nach der Dicke des Trägers (200) richtet, wobei die Bildung der Säule (300) die Bildung eines Halteelements (402) für die Säule (300) innerhalb derselben umfasst, und bei dem Verfahren darüber hinaus das Halteselement (402) die Wand (101) des Lochs (100) berührt entsprechend der Höhe des Lochs (100), wobei die Berührung von Halteelement (402) und Wand (101) des Loches (100) durch plastische Verformung des Halteelements (402) erfolgt,
   - die Bildung eines Zwischenraums (105) der leer ist oder zumindest teilweise zwischen mindestens einem teil der Wand (101) des Lochs (100) und einem Teil der Außenwand der Säule (300) mit dielektrischem Gas gefüllt ist.

10. Verfahren nach dem vorhergehenden Patentanspruch, in dem die plastische Verformung des Halteelements (402) durch Kompression oder Thermokompression der im Loch (100) befindlichen Säule erfolgt.

11. Verfahren nach einem der beiden vorhergehenden Patentansprüche, in welchem die Bildung des Halteelements (402) den Auftrag einer Materialschicht auf einem Teil (305) des Abschnitts der Säule (300) umfasst, welche das Halteelement (402) bildet, wobei besagtes Material so ausgewählt wird, dass seine Streckgrenze kleiner ist als die des Materials des Teils (305) des Abschnitts.

12. Verfahren nach einem der drei vorgenannten Patentansprüche, in dem die Bildung der Säule die Bildung von zumindest einem anderen Halteelement (402) umfasst, welches vom ersten entsprechend der Höhe der Säule (300) entfernt ist.

13. Verfahren nach den Patentansprüchen 9 bis 12, in welchem das Material des Halteelements (402) eine Legierung ist, und das Verfahren die Umwandlung besagter Legierung in eine intermetallische Verbindung umfasst, nachdem das Halteorgan (402) mit der Wand (101) des Lochs (100) in Kontakt kam.

14. Verfahren nach den Patentansprüchen 9 bis 13, in welchem die Bildung der Säule (300) die Herstellung eines leitfähigen Elements (401) an der Basis eines Teils des Abschnitts der Säule (300) umfasst, wobei das Material des leitfähigen Elements (401) eine Streckgrenze aufweist, die unter der des Materials des Abschnittteils liegt, wobei das Verfahren des Weiteren die plastische Verformung des leitfähigen Elements (401) durch Kompression oder Thermokompression der Säule (300) bei Kontakt mit einem elektrisch leitfähigen Aufnahmeelement umfasst, wobei im Verfahren als Aufnahmeelement vorzugsweise ein elektrischer Aufnahmebereich (130) verwendet wird, der in Höhe des zweiten Endes des Loches (100) gebildet wird.

15. Verfahren nach Patentanspruch 11 oder in Kombination mit einem der Patentansprüche 12 bis 14, in welchem die Bildung der Säule (300) die Bildung eines Abschnitts der Säule (300) mit einem Durchmesser umfasst, der kleiner ist als der des Lochs (100), und die Bildung des Halteelements (402) mit einem Durchmesser, der kleiner ist als der des Lochs (100), und in dem der Kontakt des Haltelements mit der Wand (101) des Lochs (100) durch Kompression oder Thermokompression des Halteelements erfolgt, bei der dessen Querschnitt bis zum Kontakt vergrößert wird.

16. Verfahren nach einem der Ansprüche 9 bis 15, in welchem die Bildung der Säule folgendes umfasst:

   - eine Phase der Herstellung der Säule (300) ausgehend von einem zweiten Träger (200), der sich vom Träger (200) unterscheidet,
   - eine Phase des Einführens der Säule (300) in das Loch (100).

17. Verfahren nach einem der Patentansprüche 9 bis 14, in welchem die Bildung der Säule Folgendes umfasst:

- eine Phase der Herstellung der Säule (300) ausgehend von einem zweiten Träger (200), der sich vom Träger (200) unterscheidet,
- eine Phase des Einführens der Säule (300) in das Loch (100).

und in der die Phase der Herstellung der Säule die Bildung eines Säulenabschnitts umfasst, der kleiner ist als der Durchmesser des Lochs (100), und die Bildung des Halteelements (402) mit einem Durchmesser, der größer ist als der Durchmesser des Lochs(100);

und in dem die Herstellung des Kontakts die plastische Verformung eines Teilstücks am Rand des Halteelements (402) umfasst, das in der Phase des Einführens in Kontakt mit einem Teil der Fläche des Lochs (100) kommt, wobei das Material, welches das Halteelement (402) bildet, so auszuwählen ist, dass seine Streckgrenze kleiner ist als die des Materials des Teils der Fläche des Loches (100).

18. Verfahren nach einem der beiden vorhergehenden Patentansprüche, in dem der zweite Träger (200) nach dem Einfügen entfernt wird, so dass sich nur noch die Säule im Träger (200) befindet.

19. Verfahren nach einem der Patentansprüche 9 bis 15, in dem die Bildung der Säule (300) folgendes umfasst:

- eine Phase des Befüllens des Lochs mit Harz,
- eine Phase, in der im Harz durch Lithografie die Struktur der Säule (300) gebildet wird,
- eine Phase, in der in der Struktur mindestens eine Materialschicht aufgetragen wird, die die Säule (300) bildet;
- eine Phase, in der das Harz zumindest teilweise entfernt wird,

und die vorzugsweise vor dem Befüllen den Auftrag einer kontinuierlichen, elektrisch leitfähigen Grundschicht in dem Loch umfasst, und in welcher der Auftrag durch elektrochemische Beschichtung erfolgt.

**Claims**

1. An electronic component comprising:

- a substrate (200) and at least one hole (100) at least partly passing through the thickness of the substrate (200);
- an electrically conductive element situated in the hole (100) and configured so as to form an electrical connection through the hole (100), the electrically conductive element comprising an electrically conductive self-supporting pillar (300), the height of which is oriented across the thickness of the substrate (200),
- a space (105), void or at least partially filled with a dielectric gas, between at least part of the wall of the hole (100) and a part of the peripheral wall of the pillar (300);

in which the pillar (300) comprises a member (402) for holding the pillar (300) in position in contact with the wall (101) of the hole (100) along the height of the hole (100), the holding member (402) being a portion forming a part of the height of the pillar (300);

in which the holding member (402) is superimposed with a part (305) of the trunk of the pillar (300);

and in which the material of the holding member (402) is different from the material of the trunk part (305) and has a limit of elasticity less than that of the material of the trunk part (305).

2. A component according to the preceding claim, in which the holding member (402) is configured so as to close the space (105) in an airtight manner.

3. A component according to one of the preceding claims, in which the holding member (402) is situated at a first end of the hole (100).

4. A component according to one of the preceding claims, comprising at least one other holding member (402) spaced apart from the first holding member (402) along the height of the pillar (300).

5. A component according to one of the preceding claims, comprising an area (130) for making electrical contact at a second end of the hole (100), and in which the pillar (300) comprises a conductive member (401) in contact with the area (130) for making electrical contact and with a part (305) of the trunk of the pillar, and in which the material of the conductive member (401) is different from the material of the trunk part (305) and has a limit of elasticity less than that of the material of the trunk part (305).

6. A component according to one of the preceding claims, in which the space (105) is closed.

7. A component according to any one of the preceding claims, in which the substrate (200) is at least partially made from semiconductor material and/or the wall of the hole is at least partially formed by the surface of an insulation layer (210).

8. A component according to one of the preceding claims, comprising a plurality of holes and a plurality of pillars (300), at least two of which have different heights.

9. A method for creating an electrical connection through at least part of the thickness of a substrate (200) of an electronic component, comprising:

   - the formation of a hole (100) passing through at least part of the thickness of the substrate (200);
   - the formation of an electrically conductive element situated in the hole (100) and configured so as to form the electrical connection through the hole (100), the formation of the electrically conductive element comprising:
   - the formation of an electrically conductive self-supporting pillar (200) forming part of the electrically conductive element (300) and the height of which is oriented across the thickness of the substrate (200), the formation of the pillar comprising the formation, in the pillar (300), of a holding member (402) for holding the pillar (300) in position, the method further comprising putting the holding member (402) in contact with the wall (101) of the hole (100) along the height of the hole (100), the putting in contact of the holding member (402) and the wall (101) of the hole (100) being done by plastic deformation of the holding member (402),
   - the formation of a space (105) that is void or at least partially filled with a dielectric gas between at least part of the wall (101) of the hole (100) and a part of the peripheral wall of the pillar (300).

10. A method according to the preceding claim, in which the plastic deformation of the holding member (402) is done by compression or thermocompression of the pillar present in the hole (100).

11. A method according to one of the preceding two claims, in which the formation of the holding member (402) comprises the deposition, on a trunk part (305) of the pillar (300), of a layer of material constituting the holding member (402), said material being selected so that its limit of elasticity is less than that of the material of the trunk part (305).

12. A method according to one of the three claims, in which the formation of the pillar comprises the formation of at least one other holding member (402) spaced apart from the first along the height of the pillar (300).

13. A method according to claims 9 to 12, in which the material of the holding member (402) is an alloy, the method comprising the transformation of said alloy into an intermetallic material after the holding member (402) and the wall (101) of the hole (100) are put in contact.

14. A method according to one of claims 9 to 13, in which the formation of the pillar (300) comprises the production of a conductive member (401) at the base of a trunk part of the pillar (300), the material of the conductive member (401) having a limit of elasticity less than that of the material of the trunk part, the method further comprising the plastic deformation of the conductive member (401) by compression or thermocompression of the pillar (300), in contact with an electrically conductive support element, the method preferably comprising the use, as the support element, of an area for making electrical upturn contact (130) formed at a second end of the hole (100).

15. A method according to claim 11 alone or in combination with one of claims 12 to 14, in which the formation of the pillar (300) comprises the formation of a pillar trunk (300) with a diameter less than that of the hole (100) and the formation of the holding member (402) with a diameter less than that of the hole (100), and in which the putting in contact comprises the compression or thermocompression of the holding member so as to increase its cross-section until contact is made with the wall (101) of the hole (100).

16. Method according to one of claims 9 to 15, in which the formation of the pillar comprises:

   - a step of manufacturing the pillar (300) from a second substrate (200') different from the substrate (200),
   - a step of inserting the pillar (300) in the hole (100).

17. A method according to one of claims 9 to 14, in which the formation of the pillar comprises:

- a step of manufacturing the pillar (300) from a second substrate (200') different from the substrate (200),
- a step of inserting the pillar (300) in the hole (100);

and in which the step of manufacturing the pillar comprises the formation of a pillar trunk with a diameter less than the diameter of the hole (100) and the formation of the holding member (402) with a diameter greater than the diameter of the hole (100);

and in which the putting in contact comprises the plastic deformation of a peripheral portion of the holding member (402) in contact with a surface portion of the hole (100) during the insertion step, with preferably the material constituting the holding member (402) chosen so as to have a limit of elasticity less than that of the material of the surface portion of the hole (100).

18. A method according to one of the preceding two claims, in which the second substrate (200') is removed after the insertion step so as to leave only the pillar in the substrate (200).

19. A method according to one of claims 9 to 15, in which the formation of the pillar (300) comprises:

- a step of filling the hole with a resin;
- a step of lithography in the resin configured so as to form a pillar pattern (300);
- a step of depositing in the pattern at least one layer of material constituting the pillar (300);
- a step of at least partial removal of the resin,

and preferably comprising, before the filling step, a step of depositing an electrically conductive continuous bottom layer in the hole, and in which the deposition step is performed by electrochemical deposition.

Art antérieur

Figure 1a

Figure 1b

Figure 1c

300

315

200'

Figure 2a

1

210

100

210

200

101

200

2

Figure 2b

12

310

300

210

210

200

130

500

Figure 2c

Figure 3a

Figure 3b

Figure 3c

Figure 4

Figure 5

Figure 6a

Figure 6b

Figure 6c

24

Figure 7

Figure 8

Figure 9

Figure 10

Figure 11

Figure 12

300

211

210

200

Figure 13

300

402

211

200

Figure 14

300    402    110

211

210

200

130

Figure 15

**EP 2 791 969 B1**

## RÉFÉRENCES CITÉES DANS LA DESCRIPTION

**Documents brevets cités dans la description**

- WO 2010119652 A1